# EUROPÄISCHE PATENTANMELDUNG

(11) **EP 1 914 489 A1**
(43) Veröffentlichungstag der Anmeldung: **23.04.2008**
(21) Anmeldenummer: 07019789.2
(22) Anmeldetag: 10.10.2007
(51) Int. Cl.: F24J 2/24, H01L 31/052, H01L 31/058

(54) **Photovoltaikmodul mit Kühleinrichtung**

(30) Priorität: 21.10.2006 DE 102006049790; 13.06.2007 DE 102007027207
(71) Anmelder: SUNZENIT GmbH, 14715 Märkisch Luch OT Buschow (DE)
(72) Erfinder: Bieber, Lothar, 14715 Märkisch Luch - OT Buschow (DE)
(74) Vertreter: Bergelt, Klaus

(57) **Zusammenfassung**

Der Wirkungsgrad von Solarzellen bzw. Photovoltaikmodulen sinkt bei starker Erwärmung bis zu 80 % seiner Gesamtleistung. Die vorliegende Erfindung hat sich daher die Aufgabe gestellt, ein Photovoltaikmodul mit einer entsprechenden Kühlung zu entwickeln, welches technologisch einfach gestaltet und industriell preiswert herstellbar ist.

So setzt sich das Photovoltaikmodul aus zwei miteinander durch Klebung fest verbundener Elementen innerhalb eines speziellen Rahmens (1) mit den notwendigen elektrischen Anschlüssen zusammen, nämlich einem Glas/Glas-Modul (4), dessen Abmessungen von der Größe des Zelltyps abhängt, und einer mit Wasser durchströmten Kühleinrichtung. Das spezielle Abmessungen aufweisende Glas/Glas-Modul (4) besteht aus ESG-Glas (5), Folie (6), Siliziumzellen und nach außen geführte Strombänder. Die auf der Rückseite befestigte Kühleinrichtung ist entweder ein zur Absorption der Wärme ausgeformtes Blech (8), oder eine entsprechende Kunststoffplatte (8), wobei diese an ihrer Oberseite mittels eines UVbeständigen 2K-Klebers (3) wetterfest und wasserdicht verschlossen sind.

Vorteilhaft ist, dass das Photovoltaikmodul universell in kalten sowie heißen Ländern eingesetzt werden kann.

## Beschreibung

Die Erfindung betrifft ein Photovoltaikmodul mit einer Kühleinrichtung.

Es ist bekannt, dass der Wirkungsgrad bekannter Solarzellen bei starker Erwärmung erheblich sinkt. D.h., die elektrische Leitfähigkeit eines Halbleiters, meist aus Silizium ist sehr stark temperaturabhängig. Je nach Temperatur kann er sowohl als Leiter als auch als Nichtleiter betrachtet werden. Bei Temperatur unter 0 Grad C sind sie gewöhnlich nicht leitend. Die elektrische Leitfähigkeit eines Halbleiters nimmt mit steigender Temperatur zu, womit dieser in seinem Wirkungsgrad stark abfällt, D.h., bis zu 80 % seiner Gesamtleistung. Es sind bereits Lösungen bekannt, um die Leistungsfähigkeit von Photovoltaikanlagen zu verbessern. So beschreibt die

DE 197 47 325 A1 Solarzellmodule mit integrierter Kühlung der Solarzellen. Hier werden, um den Wirkungsgrad von Solarzellen an heißen Tagen zu steigern, diese auf ein möglichst gut wärmeleitendes Metallgefäß montiert, welches mit flüssigem Kühlmittel gefüllt ist. Dieser Behälter soll jetzt die an den PV-Modulen entstandene Wärme über Lamellen an die Flüssigkeit übertragen. Nachteilig bei dieser Ausführung des Kühlsystems ist, dass ein universeller Einsatz des Moduls so nicht möglich ist. Gleiches gilt auch für die Steuerbarkeit, woraus folgt, dass bei Schneefall der Schnee auf den Modulen liegen bleibt und für längere Zeit ausfällt. Zusätzlich besteht das Problem, dass in Wüstenregionen bei der Befüllung der Anlage nur wenig Wasser zur Verfügung steht und bei großen Mengen ein Belüftungsproblem entsteht.

Ferner verwendet die in der DE 202 14 078 U1 vorgestellte Photovoltaikeinrichtung einen extrudierten transparenten Kunststoffkanal, in dem die PV-Zellen in einem verlöteten Strang direkt im Kühlmedium schwimmen, so dass die bestrahlte PV-Zelle nicht nur von vorn, sondern ringsherum an die im Kunststoffkanal befindliche Kühlflüssigkeit die Erwärmung allseitig und zugleich abgeben soll. Abgesehen davon, dass bei dieser Lösung als optisches Gerät, lediglich Konzentratorzellen, die auf Dauer den harten Einsatz in der Natur nicht standhalten, zum Einsatz vorgesehen sind, erfordert die Lösung ferner eine spezielle nicht leitende und eine gute lichtdurchlässige Flüssigkeit, die wiederum einen hohen Kostenfaktor darstellt. Außerdem kann bei chemischen Kühlflüssigkeiten eine negative Reaktion auf die einzelnen Komponenten einwirken.

In der DE 102 00 400 2900 A1 wird ein Solarmodul beschrieben, wo auf ein Photovoltaikmodul ein Aluminiumrahmen mit bruchsicherer Scheibe und wasserdichter Gummidichtung aufgespannt ist, wobei der Aluminiumrahmen unten Düsen unterschiedlicher Größe aufweist, so dass Wasser den schmalen Zwischenraum gleichmäßig durchströmen kann.

Bei dieser Konstruktionen besteht die Gefahr das das Glas, welches auf der Vorder-oder Rückseite befestigt ist, durch zu hohen Druck des Kühlmittels bricht, da sich die Druckkraft auf die Scheibe proportional zur Erhöhung des Kühlmitteldrucks und Vergrößerung der Oberfläche erhöht. D.h., die Druckkraft auf die Scheibe steigt mit der zu kühlenden Fläche und somit steigt die Gefahr des Glas- bzw. Modulbruchs. Gleichfalls muss mit steigendem Druck die Glasstärke und Güte der Scheibe/Modul erhöht werden. Die Folge ist, dass sich die Lichtintensität bei einem vor dem Modul angebrachten Kühlsystem, beispielsweise durch die Eintrübung der Kühlflüssigkeiten, erheblich verringert und so der Wirkungsgrad sinkt. Analoge Nachteile, wie eben beschrieben, treffen gleichfalls für die in der DE 199 23 196 A1 aufgeführte Lösung - Rekuperatives sellektives Flüssigkeitsfilter für Photovoltaikmodule - zu. Hier dient eine der Strahlung ausgesetzte Vorderseite und eine gegenüberliegende Rückseite der Umwandlung von Strahlungsenergie in elektrische Spannungen. Die Kühleinrichtung ist gleichfalls zwischen der Vorderseite und Strahlungsquelle angeordnet. Durch die Gewichtserhöhung des gesamten Moduls ist die Montage eingeschränkt und der Einsatz des Kühlmediums im Hausgebrauch auf Grund der geringen Temperatur uneffektiv. Bei der Kühlung von Photovoltaikmodulen zur Erhöhung der Leistungsausbeute nach der DE 101 21 850 A1, wird das Kühlwasser auf der Rückseite eines handelsüblichen Moduls durch einen Zwischenraum geführt, der sich durch das Aufkleben einer Glasscheibe mittels Silikon ergibt. Die auf der Rückseite auflaminierte Folie ist jedoch nicht hundertprozentig diffusionsdicht, so dass das Kühlmittel bis zu den Siliziumzellen vordringt und so einen Kurzschluss auslösen kann. Das als Klebemittel verwendete Silikon löst bei Kontakt mit der PVB-Folie eine negative Reaktion aus, so dass eine irreparabele Beschädigung eintritt. Aufgabe der Erfindung ist daher, unter Vermeidung der genannten Nachteile ein Photovoltaikmodul zu entwickeln, welches durch eine entsprechende Kühlung nicht nur seine angestrebte Leistung behält, sondern gleichzeitig technologisch einfach gestaltet und somit industriell preiswert herstellbar ist, bei gleichzeitiger Wartungsmöglichkeit.

Die Aufgabe wird erfindungsgemäß durch die Merkmale des Patentanspruches 1 und den Unteransprüchen gelöst. Durch die Erfindung wird ermöglicht, dass durch ein spezifisches Glas/Glas-Modul als Einheit mit einer Kühleinrichtung eine enorme Leistungsausbeute erreicht wird, bei gleichzeitiger Nutzung einfachster technologischer Maßnahmen bei der Verbindung Glas/Glas-Modul, sowie die kostengünstige Herstellung tiefgezogener Bleche für die Kühlung. Wesentlich ist ferner, dass durch die Verwendung eines gesonderten universell um das gesamte Modul anbringbares Elektroanschlussprofiles alle Verkabelungen und Querschaltungen sowie die Herausführung der Strombänder aus dem Glas/Glas-Modul außerhalb der Photovoltaikeinrichtung unsichtbar angesiedelt sind und durch Verschraubung so jederzeit eine Wartung bzw. Reparatur ermöglicht ist.
Im folgenden wir anhand eines Ausführungsbeispieles die Erfindung näher erläutert. Es zeigt:
Fig. 1 eine Seitenansicht des Photovoltaikmodul im Schnitt senkrecht stehend

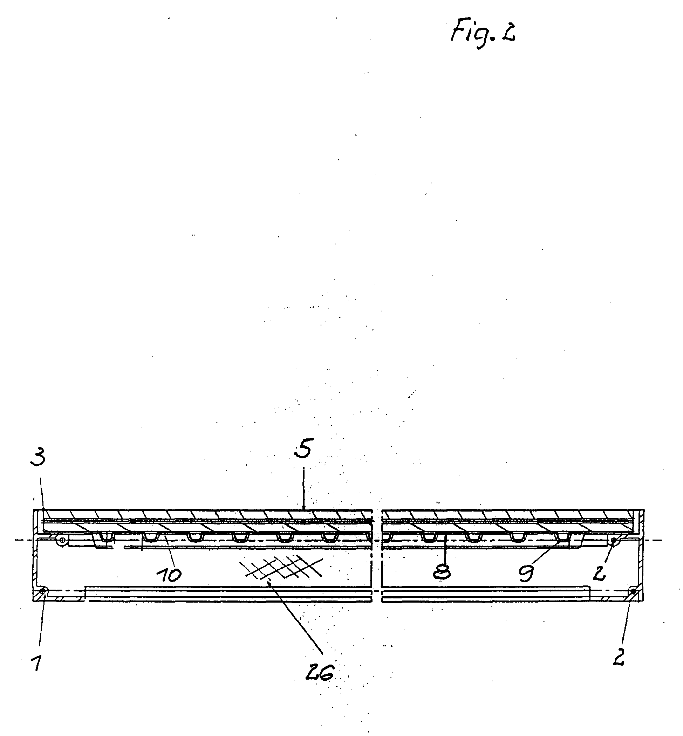

Fig. 2 einen Querschnitt des Photovoltaikmoduls waagerecht liegend

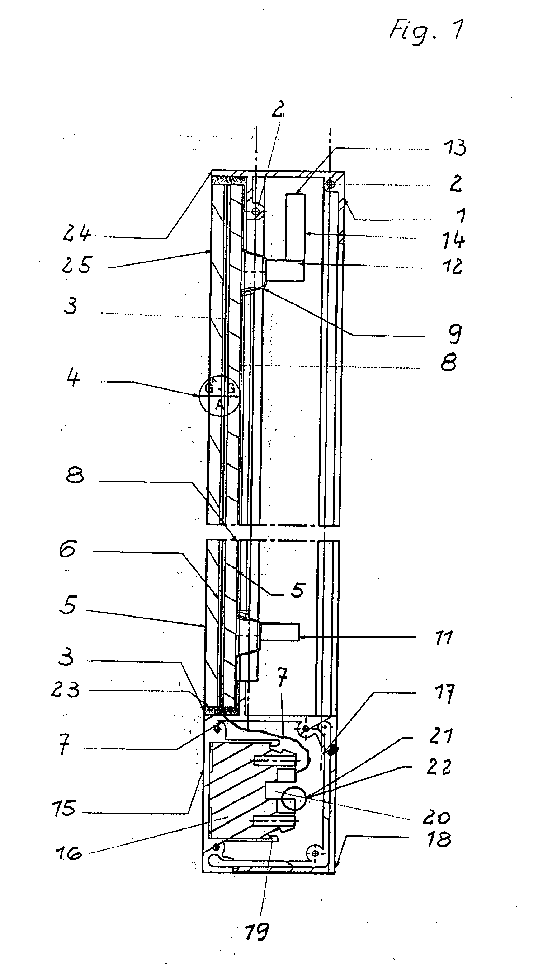

Wie aus Fig. 1 ersichtlich, sind alle notwendigen Elemente des Photovoltaikmoduls in einem speziellen Rahmen 1, beispielsweise aus Alu, mit Schraubkanälen 2 für die stumpfe Verschraubung sowie für die Eckenverpressung untergebracht. Für die im Rahmen 1 als Oberfläche mittels UV-beständigem 2K-Kleber eingeklebte Solareinheit findet ein spezielles Glas/Glas Modul 4 Verwendung, dessen Abmessungen von der Größe des Zelltyps abhängt und sich aus ESG-Glas 5, Folie 6, Siliziumzellen und Strombänder 7, für die mögliche Ableitung des Stromes auf der Vorderseite als auch auf der Hinterseite, zusammensetzt.

Die vorgesehene Kühleinrichtung wird auf die Rückseite des Glas/Glas Modul 4 gleichfalls mit UV-beständigem 2K-Kleber 3 aufgeklebt. Sie besteht aus einem entsprechend zur Absorption der Wärme ausgeformtem Blech 8 oder einer entsprechenden Kunststoffplatte 8.

Die im Blech 8 oder in der Kunststoffplatte 8 U-förmig tief eingebrachten Kanäle 9 (längs oder quer) sind so ausgeformt, dass sie auf der Innenseite bzw. an der oberen Seite der U-Form entsprechend breit und gerade sind, so dass eine stabile Auflage und Klebefläche 10 zwischen dem Blech 8 oder Kunststoffplatte 8 und ESG-Glas 5 entsteht. Als Kleber eignet sich hier gleichfalls ein UV-beständiger 2K-Kleber. Die so angewandte Technik ermöglicht auch größere Glasscheiben 4 mit dem Blech 8 oder der Kunststoffplatte 8 zu verkleben. Es wird so eine große Fläche geschaffen mit vielen kleinen Kanälen 9, so dass sich der Wasserdruck bei Erwärmung optimal verteilt.

Das Blech 8 ist mit einem oder mehreren Vor- und Rücklaufstutzen 11;12 versehen. Die Entlüftung mittels eines Entlüftungsventils 13 kann am höchsten Punkt der Kühleinrichtung aber auch außerhalb des Photovoltaikmoduls an der Rücklaufleitung 14 erfolgen.

Völlig abweichend von den in der Praxis bekannten Solarmodulen mit im Modul integrierten und während der Laufzeit unzugänglichen Anschlussdosen, ist bei der vorliegenden Lösung im Rahmen 1 ein Elektroanschlussprofil 15 über die gesamte untere Breite des Photovoltaikmoduls zur Verkabelung einzelner Module sowie zur Aufnahme einer Moduldose 16, die links, rechts oder oben anschraubbar ist, eingefügt. Das Elektroanschlussprofil 15 besteht aus UV-beständigem Kunststoff, mit anexdrudierten Dichtungslippen 17. Ein Deckel 18, wird auf das Elektroanschlussprofil 15 geklippt oder mit diesem verschraubt. So wird ermöglicht, dass Querschaltungen durch die besondere Anordnung des Elektroanschlussprofiles 15 außerhalb vom Glas/ Glas Modul 4 verschaltbar ist. Gleiches gilt für die Zugänglichkeit der sich außerhalb des Glas/ Glas Modul 4 befindlichen Strombänder 7. Anexdrudierte Klipp-Haken 19 dienen der Arretierung der Modul-Dose 16 mit Anschlussklemmen 20, die über die gesamte Profilbreite verschiebbar sind. Gleichfalls verdeckt verlegt sind im Elektroanschlussprofil 15 die Anschlussklemmen von Modul zu Modul. Notwendige Dioden 21 sind so angeordnet, dass sie mit Kühlrippenklipps 22 aus stranggepresstem Aluminium bestückbar sind, um eine Überhitzung der Dioden 21 auszuschließen. Das Elektroanschlussprofil 15 in Verbindung mit dem Alu-Rahmen 1 ergibt die Umrahmung der Kühleinrichtung. Je nachdem auf welcher Seite das Elektroanschlussprofil 15 angebracht wird, werden die anderen drei Seiten mit dem Rahmen 1 umrahmt. Die entstandene kompakte und vorgefertigte Einheit Glas/Glas-Modul 4 und Kühleinheit wird im Gesamtrahmen mit einem geringen Abstand 23 zur Berücksichtigung unterschiedlicher Längenausdehnungskoeffizienten unterschiedlicher Materialien gleichfalls mit einem 2K-Kleber verklebt.

Die Rahmenoberkante 24 und die Glasfläche 25 ergeben eine ebene Fläche ohne Kante. Moosbildung durch eindringende Feuchtigkeit sowie Frostschäden durch Eis und Schnee werden so vermieden. Bei einem angedachten Einsatz der Erfindung in Wüstengebieten wird auf der Rückseite der Kühleinrichtung eine bewegliche Isolierung 26 angebracht, die nachts mit thermischen Zylindern geöffnet wird, so dass durch die niedrigen Nachttemperaturen eine schnellere Kühlung der Kühlflüssigkeit in einem Pufferspeicher verstärkt wird. Am Tag liegt die Isolierung 26 automatisch an der Rückseite der Kühleinrichtung an und schützt das gesamte Photovoltaikmodul vor hohen Außentemperaturen.

### Bezugszeichen

- 1: Rahmen
- 2: Schraubkanäle
- 3: Kleber
- 4: Glas/Glas-Modul
- 5: ESG-Glas
- 6: Folie
- 7: Strombänder
- 8: Blech / Kunststoffplatte
- 9: Kanäle
- 10: Klebefläche
- 11: Vorlaufstutzen
- 12: Rücklaufstutzen
- 13: Entlüfterventil
- 14: Rücklaufleitung
- 15: Elektroanschlussprofil
- 16: Moduldose
- 17: Dichtungslippe
- 18: Deckel
- 19: Klipphaken
- 20: Anschlussklemme
- 21: Dioden
- 22: Kühlrippenklipps
- 23: Abstand
- 24: Rahmenoberkante
- 25: Glasfläche
- 26: Isolierung

## Patentansprüche

1. Photovoltaikmodul mit Kühleinrichtung unter Verwendung teilweise handelsüblicher Bauteile **dadurch gekennzeichnet, dass** sich das Photovoltaikmodul aus zwei miteinander durch Klebung fest verbundenen Elementen innerhalb eines speziellen Rahmen (1) mit den notwendigen elektrischen Anschlüssen zusammensetzt, nämlich einem Glas/Glas-Modul (4), dessen Abmessung von der Größe des Zelltyps abhängt, und einer mit Wasser durchströmten Kühleinrichtung, wobei das spezielle Abmessungen aufweisende Glas/Glas-Modul (4) aus ESG-Glas (5), Folie (6), Siliziumzellen und nach außen geführte Strombänder (7) besteht und die auf der Rückseite befestigte Kühleinrichtung ein zur Absorption der Wärme ausgeformtes Blech (8) oder eine entsprechende Kunststoffplatte (8) aufweist, wobei diese an ihrer Oberseite mittels eines UV beständigen 2K-Klebers (3) fest und wasserdicht verschlossen sind.

2. Photovoltaikmodul nach Anspruch 1, **dadurch gekennzeichnet, dass** das aus korrosionsbeständigem Material bestehende Blech (8) oder die Kunststoffplatte (8), tief eingebrachte U-förmige Kanäle (9) aufweist, die in alle Richtungen einbringbar sind und die an der oberen offenen Seite der U-Form, beidseitig, zur Verklebung des Bleches (8) oder der Kunsfoffplatte (8) mit dem ESG-Glas (5) breite Auflage- bzw. Klebeflächen (10) aufweisen.

3. Photovoltaikmodul nach Anspruch 1 und 2 **dadurch gekennzeichnet, dass** das Blech (8) oder die Kunststoffplatte (8) mit einem oder mehreren Vor- und Rücklauf- stutzen (11;12) ausgerüstet ist, wobei die Entlüftung der durch eines am höchsten Punkt der Kühleinrichtung befindlichen Entlüftungsventils (13) oder außerhalb des Photovoltaikmoduls an der Rücklaufleitung (14) erfolgt.

4. Photovoltaikmodul nach Anspruch 1 **dadurch gekennzeichnet, dass** das Glas/Glas-Modul (4) sowie die Kühleinrichtung in einem, entsprechende Ausnehmungen aufweisenden Rahmen (1) mit Schraubkanälen (2) aus Aluminium oder einem anderen dafür geeigneten Material kompakt untergebracht ist an dem gleichzeitig über die gesamte Breite des Photovoltaikmoduls ein Elektroanschlussprofil (15) mit anexdruierten Dichtlippen (17), zur Aufnahme einer Moduldose (16) und zur Verkabelung einzelner Module integriert ist.

5. Photovoltaikmodul nach Anspruch 4 **dadurch gekennzeichnet, dass** ein Deckel (18) mit dem Elektroanschlussprofil (15) klippbar oder mit diesem verschraubt ist und andere gleichfalls anexdruierte Klipp/Haken (19) der Arretierung der Moduldose (16) mit Anschlussklemmen (20), die über die gesamte Profilbreite verschiebbar sind, dienen.

6. Photovoltaikmodul nach Anspruch 4 und 5 **dadurch gekennzeichnet, dass** notwendige Dioden (21) so angeordnet sind, dass sie mit Kühlrippenclips (22) aus stangengepresstem Aluminium bestückbar sind um eine Überhitzung auszuschließen.

7. Photovoltaikmodul nach den vorherigen Ansprüchen **dadurch gekennzeichnet, dass** das Elektroanschlussprofil (15) in Verbindung mit dem Rahmen (1) gleichzeitig die Umrahmung der Kühleinrichtung bildet, so dass je nachdem, auf welcher Seite das Elektroanschlussprofil (15) angebracht ist, die anderen drei Seiten vom Rahmen (1) umschlossen werden wobei eventuelle unterschiedliche Längenausdehnungen durch einen beidseitigen Abstand (23) vom Glas/Glas-Modul (4) zur Kühleinheit Berücksichtigung finden.
